# FASCICULE DE BREVET EUROPEEN

(11) **EP 2 464 198 B1**
(45) Date de publication et mention de la délivrance du brevet: **22.05.2013**
(21) Numéro de dépôt: 11354073.6
(22) Date de dépôt: 06.12.2011
(51) Int. Cl.: H05B 33/08

(54) **Dispositif et procédé d'alimentation pour système d'éclairage à diodes électroluminescentes et ensemble d'éclairage comportant un tel dispositif**
Vorrichtung und Verfahren für Strom-System LED-Beleuchtung und die Beleuchtung der Montage mit einer solchen Vorrichtung
Apparatus and method for power system LED lighting and lighting assembly comprising such a device

(30) Priorité: 13.12.2010 FR 1004837
(43) Date de publication de la demande: 13.06.2012
(73) Titulaire: Schneider Electric Industries SAS, 92500 Rueil-Malmaison (FR)
(72) Inventeur: Persegol, Dominique, 38050 Grenoble Cedex 09 (FR); Lovato, Jean-Louis, 38050 Grenoble Cedex 09 (FR)
(74) Mandataire: Tripodi, Paul

(56) Documents cités:
- EP-A1- 1 379 108
- EP-A2- 1 244 334
- EP-A2- 1 411 750
- WO-A2-2007/102106
- WO-A2-2008/152565
- US-A1- 2010 117 561
- US-B1- 6 285 140

## Description

### DOMAINE TECHNIQUE

L'invention concerne un dispositif d'alimentation comportant :
- une alimentation à courant continu fournissant une tension ou un courant limité sur des sorties pour l'alimentation d'un système d'éclairage à diodes électroluminescentes, ladite alimentation comportant des moyens de mesure de tension et des moyens de mesure de courant pour contrôler une tension et un courant d'alimentation, et
- des moyens de sélection de tension ou de courant connectés à ladite alimentation pour sélectionner la tension ou le courant à appliquer audit système d'éclairage à diodes électroluminescentes.

L'invention concerne aussi un ensemble d'éclairage à diodes électroluminescentes comportant au moins un dispositif d'alimentation destiné à être connecté à un réseau d'alimentation électrique, au moins un système d'éclairage à diodes électroluminescentes connecté audit au moins un dispositif d'alimentation.

L'invention concerne aussi un procédé d'alimentation pour système d'éclairage à diodes électroluminescentes comportant :
- la sélection d'une tension ou d'un courant d'alimentation à appliquer audit système d'éclairage à diodes électroluminescentes, et
- le contrôle de ladite tension et dudit courant d'alimentation.

### ETAT DE LA TECHNIQUE

Les dispositifs d'alimentation pour système d'éclairage à diodes électroluminescentes comportent généralement deux bornes de sortie sur lesquelles sont connectées des modules d'éclairage à diodes électroluminescentes. Ces modules d'éclairage comportent des diodes électroluminescentes connectées en série ou en série/parallèle selon la tension d'alimentation et le mode d'alimentation en courant ou en tension. Les tensions d'alimentation ou les courants sont prédéfinis par les constructeurs. Par exemple, les tensions d'alimentation normalisée ou habituelles sont de 12, 24 ou 48 volts en tension continue. Généralement, les constructeurs fournissent les alimentations avec les modules d'éclairage et leurs propres connecteurs détrompés. Dans un autre exemple, un brevet US7135664 décrit un schéma complet d'un système d'éclairage à diodes électroluminescentes avec des alimentations en courant.

Cependant, les alimentations peuvent être approvisionnées séparément des modules d'éclairage. Cela permet plus de souplesse et de possibilité dans les installations d'éclairage à diodes électroluminescentes. Il existe des alimentations dites universelles qui proposent plusieurs tensions et courants d'alimentation électrique. De telles alimentations comportent généralement une multitude de bornes pour connecter les modules d'éclairage sur les sorties en tensions ou en courants approprié et en tenant compte aussi de la polarité des modules d'éclairage. D'autres alimentations comportent des commutateurs pour sélectionner les tensions ou les courants d'alimentation ainsi que la polarité. Une telle sélection manuelle du type d'alimentation en tension ou en courant, de la valeur de la tension ou du courant et de la polarité comportent des risques d'erreurs pouvant entrainer une détérioration des modules d'éclairage à diodes électroluminescentes.

### EXPOSE DE L'INVENTION

L'invention a pour but un dispositif et un procédé de l'alimentation d'un système d'éclairage à diodes électroluminescentes permettant une sélection automatique de paramètres d'alimentation électrique, ainsi qu'un ensemble d'éclairage comportant un tel dispositif.

Un dispositif d'alimentation selon l'invention comportant :
- une alimentation à courant continu fournissant une tension ou un courant limité sur des sorties pour l'alimentation d'un système d'éclairage à diodes électroluminescentes, ladite alimentation comportant des moyens de mesure de tension et des moyens de mesure de courant pour contrôler une tension et un courant d'alimentation, et
- des moyens de sélection de tension ou de courant connectés à ladite alimentation pour sélectionner la tension ou le courant à appliquer audit système d'éclairage à diodes électroluminescentes,
comporte des moyens de détection automatique de sens de branchement dudit système d'éclairage comportant :
- des moyens d'injection d'au moins une impulsion de courant de test de polarité pour la détection de passage de courant,
- des moyens de traitement comportant des moyens de contrôle de tension et de courant d'alimentation pendant l'impulsion de courant de test de polarité, et
- des moyens d'inversion de sens de courant ou de tension commandés par lesdits moyens de traitement pour le contrôle du sens de passage de courant et pour l'attribution du sens de la tension ou du courant d'alimentation.

Avantageusement, lesdits moyens de traitement comportent des moyens de détection de défaut si le courant d'alimentation est passant dans les deux sens ou bloqué dans les deux sens pendant l'impulsion de courant de test de polarité.

Dans un mode de réalisation préférentiel, lesdits moyens de traitement comportent des moyens de détection de type de système d'éclairage à diodes électroluminescentes à alimentation en tension régulée ou en courant régulé, lesdits moyens de détection de type comportant des moyens de détermination d'une résistance dynamique dudit système d'éclairage à diodes électroluminescentes et des moyens de comparaison de ladite résistance dynamique à un seuil.

De préférence, lesdits moyens de traitement comportent des moyens de détermination d'une tension d'alimentation régulée pour un système d'éclairage à diodes électroluminescentes alimenté en tension comportant :
- des moyens d'injection de valeurs de tension, et
- des moyens de détection d'une tension d'alimentation en choisissant la valeur de tension la plus basse permettant de conduire un courant électrique d'alimentation supérieur à un seuil.

Avantageusement, lesdits moyens de traitement comportent des moyens de détermination d'un courant d'alimentation régulé pour un système d'éclairage à diodes électroluminescentes alimenté en courant comportant :
- des moyens d'injection des valeurs de courant pour déterminer des valeurs de tension directe à des températures ambiantes et/ou à froid avant utilisation,
- des moyens d'injection des valeurs de courant et de contrôle des variations de tension directe, et
- des moyens de détection d'un courant d'alimentation en choisissant la valeur de courant la plus basse pour laquelle une tension directe est inférieure à une portion de la valeur de tension directe à une température ambiante préenregistrée.

Dans un mode de réalisation particulier, lesdits moyens de traitement comportent des moyens de diagnostic pour détecter l'état des diodes électroluminescentes en fonctionnement, lesdits moyens de traitement comportant :
- des moyens de contrôle du courant lorsque le système d'éclairage à diodes électroluminescentes alimenté en tension et/ou des moyens de contrôle de tension directe lorsque le système d'éclairage à diodes électroluminescentes alimenté en courant, et
- des moyens de traitement d'un résultat de diagnostic lorsque le courant dépasse un seuil si le système est alimenté en tension et/ou lorsque la tension directe devient inférieure à un seuil lorsque le système est alimenté en courant.

Dans un ensemble d'éclairage à diodes électroluminescentes comportant au moins un dispositif d'alimentation destiné à être connecté à un réseau d'alimentation électrique, au moins un système d'éclairage à diodes électroluminescentes connecté audit au moins un dispositif d'alimentation, le dispositif de d'alimentation est un dispositif tel que défini ci-dessus comportant des moyens de traitement pour le traitement de la sélection automatique de l'alimentation dudit au moins un système d'éclairage à diodes électroluminescentes.

Un procédé d'alimentation pour système d'éclairage à diodes électroluminescentes selon l'invention comportant :
- la sélection d'une tension ou d'un courant d'alimentation à appliquer audit système d'éclairage à diodes électroluminescentes, et
- le contrôle de ladite tension et dudit courant d'alimentation,
comporte la détection automatique de sens de branchement dudit système d'éclairage en effectuant :
- l'injection d'au moins une impulsion de courant de test de polarité pour la détection de passage de courant,
- le contrôle de ladite tension et dudit courant d'alimentation pendant l'impulsion de courant de test de polarité, et
- l'inversion de sens de courant ou de tension pour le contrôle du sens de passage de courant et pour l'attribution du sens de la tension ou du courant d'alimentation.

Avantageusement, le procédé d'alimentation comporte la détection de défaut si le courant d'alimentation est passant dans les deux sens ou bloqué dans les deux sens pendant l'impulsion de courant de test de polarité.

Dans un mode de réalisation préférentiel, le procédé d'alimentation comporte la détection de type de système d'éclairage à diodes électroluminescentes à alimentation en tension régulée ou en courant régulé en effectuant :
- la détermination d'une résistance dynamique dudit système d'éclairage à diodes électroluminescentes, et
- la comparaison de ladite résistance dynamique à un seuil.

De préférence, le procédé d'alimentation comporte la détermination d'une tension d'alimentation régulée pour un système d'éclairage à diodes électroluminescentes alimenté en tension comportant :
- l'injection de différentes valeurs de tension, et
- la détection d'une tension d'alimentation en choisissant la valeur de tension la plus basse permettant de conduire un courant électrique d'alimentation supérieur à un seuil.

Avantageusement, le procédé d'alimentation comporte la détermination d'un courant d'alimentation régulé pour un système d'éclairage à diodes électroluminescentes alimenté en courant comportant :
- l'injection de différentes valeurs de courant pour déterminer des valeurs de tension directe à des températures ambiantes,
- l'injection de valeurs de courant et le contrôle de variations de tension directe, et
- la détection d'un courant d'alimentation en choisissant la valeur de courant la plus basse pour laquelle une tension directe est inférieure à une portion de la valeur de tension directe à une température ambiante préenregistrée.

De préférence, le procédé d'alimentation comporte la mémorisation d'au moins une valeur de tension directe du système d'éclairage à diodes électroluminescentes à une température ambiante ou à froid avant utilisation.

Dans un mode de réalisation particulier, le procédé d'alimentation comporte un diagnostic pour détecter l'état des diodes électroluminescentes en fonctionnement, et comportant :
- un contrôle du courant lorsque le système d'éclairage à diodes électroluminescentes est alimenté en tension et/ou un contrôle de tension directe lorsque le système d'éclairage à diodes électroluminescentes est alimenté en courant, et
- le traitement d'un résultat de diagnostic lorsque le courant dépasse un seuil si le système est alimenté en tension et/ou lorsque la tension directe devient inférieure à un seuil lorsque le système est alimenté en courant.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma block d'un ensemble d'éclairage pouvant comporter un dispositif selon un mode de réalisation de l'invention ;
- la figure 2 représente un schéma d'un dispositif d'alimentation d'un système d'éclairage à diodes électroluminescentes selon un mode réalisation de l'invention ;
- la figure 3 représente un schéma d'un inverseur de polarité pour un dispositif d'alimentation selon un mode de réalisation de l'invention ;
- la figure 4 représente un organigramme de détection et d'attribution de polarité pour un dispositif et un procédé selon un mode de réalisation de l'invention ;
- la figure 5 représente un organigramme général de sélection de type de module d'éclairage pour un dispositif et un procédé selon un mode de réalisation de l'invention ;
- la figure 6 illustre des courbes de caractéristiques électriques de modules d'éclairage pour des dispositifs et procédés selon des modes de réalisation de l'invention ;
- la figure 7 représente un organigramme détaillé de sélection de type de module d'éclairage pour un dispositif et un procédé selon un mode de réalisation de l'invention ;
- la figure 8 illustre une courbe de caractéristiques électriques de modules d'éclairage courant-tension pour déterminer des résistances dynamiques dans des dispositifs et procédés selon un organigramme de la figure 7 ;
- la figure 9 illustre une courbe de sélection de courant ou de tension pour des dispositifs et procédés selon des modes de réalisation de l'invention ;
- la figure 10 représente un organigramme détaillé de sélection de tension d'alimentation dans un dispositif et un procédé selon un mode de réalisation de l'invention ;
- la figure 11 représente un organigramme détaillé de sélection de courant d'alimentation dans un dispositif et un procédé selon un mode de réalisation de l'invention ;
- la figure 12 illustre des courbes de variation de tension en réponse à un créneau de courant pour la sélection de courant dans des dispositifs et procédés selon des modes de réalisation de l'invention ;
- la figure 13 représente un organigramme de diagnostic pour un dispositif et un procédé selon un mode de réalisation de l'invention ;
- la figure 14 illustre une courbe de variation de tension pour un diagnostic d'un système d'éclairage à diodes électroluminescentes à commande en courant ; et
- la figure 15 illustre une courbe de variation de courant pour un diagnostic d'un système d'éclairage à diodes électroluminescentes à commande en tension.

### DESCRIPTION DETAILLEE DE MODES DE REALISATION PREFERES

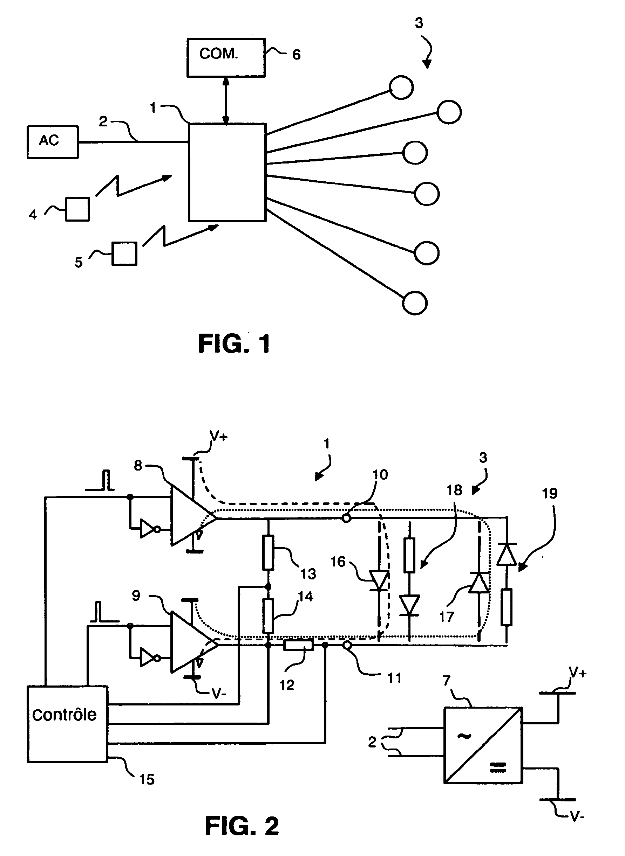

Un schéma block d'un ensemble d'éclairage à diodes électroluminescentes est représenté en figure 1. Il comporte un dispositif 1 d'alimentation destiné à être connecté à un réseau 2 d'alimentation électrique. Des systèmes d'éclairage ou des modules d'éclairage 3 à diodes électroluminescentes sont connectés au dispositif d'éclairage 1. Les contrôle d'éclairage peut être fait en utilisant des télécommandes ou des interfaces homme machine 4, des capteurs 5 de régulation de lumière, ou des module de communication 6 reliés avec ou sans fils au dispositif d'alimentation 1. Pour éviter une configuration complexe de l'alimentation des systèmes d'éclairage à diodes électroluminescentes, le dispositif d'alimentation 1 selon l'invention permet une sélection automatique de la polarité, du type d'alimentation tension ou courant, et/ou de la valeur de l'alimentation en tension ou courant.

La figure 2 représente un schéma d'un dispositif d'alimentation d'un système d'éclairage à diodes électroluminescentes selon un mode réalisation de l'invention. Ce dispositif comporte une alimentation 7 continue connectée à un réseau 2 et fournissant une tension continue à deux polarités V+ et V-. Cette tension continue est appliquée à des circuits électroniques de puissance 8 et 9 représentés par les amplificateurs. Des sorties des circuits 8 et 9 permettent d'inverser les polarités de tension ou de courant sur des bornes de sorties 10 et 11. Une résistance de mesure de courant 12 est connectée entre une sortie du circuit 9 et la borne de sortie 11 et des résistances de mesure de tension 13 et 14 sont connectées entre les deux sorties des circuits 8 et 9. Des signaux de mesure captés sur La résistance 12 de mesure de courant et les résistances 13 et 14 de mesure de tension sont fournis à un circuit 15 de traitement. Des entrées des circuits 8 et 9 sont connectées au circuit de traitement 15. Ainsi, le circuit de traitement 15 peut contrôler une tension et un courant d'alimentation en fonction de mesure de tension et de mesure de courant et de consignes prédéterminées. Dans ce cas, le dispositif d'alimentation à courant continu de la figure 2, comporte une limitation de courant ou de tension pour l'alimentation d'un système d'éclairage à diodes électroluminescentes. Dans la suite de la description, le système d'éclairage à diodes électroluminescentes est appelé aussi module d'éclairage ou luminaire.

Selon un mode de réalisation de l'invention, le dispositif de d'alimentation comporte une sélection automatique de l'alimentation dudit système d'éclairage à diodes électroluminescentes. Le système d'éclairage à diodes électroluminescentes peut être connecté dans un premier ou un second sens ou polarité, être du type à commande en tension ou en commande en courant, et avoir plusieurs tensions ou courants de fonctionnement. Sur la figure 2, les diodes électroluminescentes 16 et 17 peuvent être alimentées en courant et les diodes 18 et 19 associées à des résistances de limitation être alimentées en tension. Toutes les diodes électroluminescentes peuvent être alimentées dans un premier sens ou un second sens.

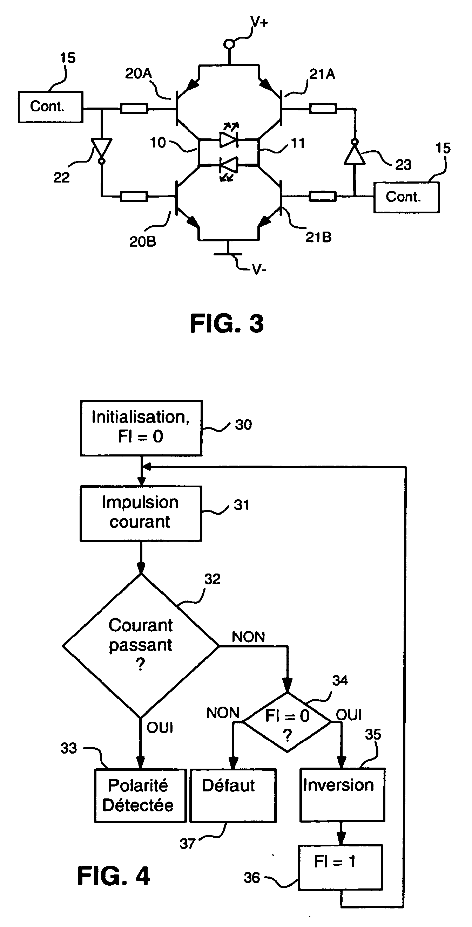

La figure 3 représente un schéma d'un inverseur de polarité pour un dispositif d'alimentation selon un mode de réalisation de l'invention. Ce circuit inverseur peut être intégré dans les circuits 8 et 9 pour inverser le sens du courant ou de la tension d'alimentation. Il comprend des transistors montés en H chaque bras comprend deux transistors respectivement 20A et 20B, et 21A et 21B commandés de manière complémentaire par des inverseurs 22 et 23.

La figure 4 représente un organigramme de détection et d'attribution de polarité pour un dispositif et un procédé selon un mode de réalisation de l'invention.

Cet organigramme comporte une étape 30 d'initialisation. Dans ce mode de réalisation, la détection automatique de sens de branchement dudit système d'éclairage est réalisée en injectant au moins une impulsion de courant de test de polarité pour la détection de passage de courant. Ainsi, une étape 31 permet d'injecter une impulsion de courant. Puis une étape 32 contrôle ladite tension et/ou le courant d'alimentation pendant l'impulsion de courant de test de polarité. Notamment, dans cette étape 32, le passage du courant est contrôlé. Si le courant est passant la polarité est détectée à une étape 33. Si le passage du courant n'est pas détecté, il y a le test d'un indicateur à une étape 34 pour connaitre un premier passage. Dans le cas d'un premier passage, indicateur à zéro, une étape 35 effectue une inversion de sens de courant ou de tension pour le contrôle du sens de passage de courant et pour l'attribution du sens de la tension ou du courant d'alimentation. Après l'inversion, une étape 36 change l'état de l'indicateur, à un par exemple. Puis, le cycle de détection de polarité recommence. L'impulsion est injectée dans un autre sens à l'étape 31, et le passage de courant est détecté à l'étape 32. Si le courant passe, le sens de courant est détecté à l'étape 33. Si non, à l'étape 34, il y a le contrôle de l'indicateur. Si l'indicateur est à un, ce qui signifie un second passage, une étape 37 indique un défaut puisque le courant ne passe dans aucun sens.

Il est possible dans un autre organigramme non représenté de détecter un défaut aussi si un courant significatif passe dans les deux sens. Ainsi, un dispositif et un procédé selon des modes de réalisation de l'invention comportent la détection de défaut si le courant d'alimentation est passant dans les deux sens ou bloqué dans les deux sens pendant l'impulsion de courant de test de polarité.

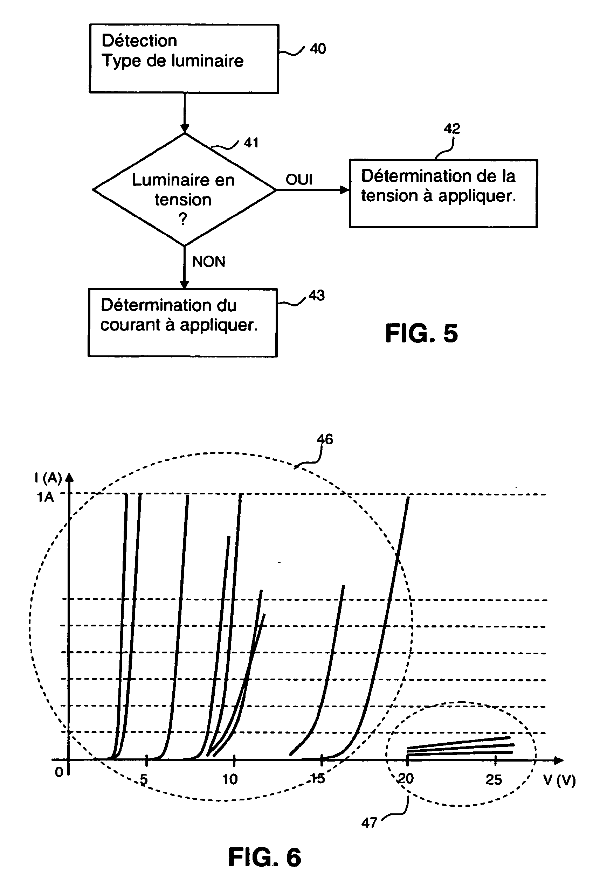

La figure 5 représente un organigramme général de sélection de type de module d'éclairage pour un dispositif et un procédé selon un mode de réalisation de l'invention. Une étape 40 initialise la détection du type de module d'éclairage en alimentation en tension ou en courant. Une étape 41 sélectionne le type de module d'éclairage. Si le module d'éclairage doit être alimenté en tension une étape 42 détermine la valeur de la tension à appliquer. Si le module d'éclairage doit être alimenté en courant une étape 43 détermine la valeur de courant à appliquer.

La figure 6 illustre des courbes de caractéristiques électriques de modules d'éclairage pour des dispositifs et procédés selon des modes de réalisation de l'invention. Les modules d'éclairage à alimenter en courant comportent généralement des diodes électroluminescentes connectés en série. Elles autorisent le passage d'un courant élevé lors d'une impulsion de test. Leurs tensions directes s'ajoutent et la tension totale est fonction du nombre de diodes. Une zone de courbe 46 délimite des courbes de diodes ou de modules d'éclairage à commander en courant. Les modules d'éclairage à alimenter en tension comportent généralement des diodes électroluminescentes comportant des convertisseurs tension-courant tels que des limiteurs de courant ou des résistances. Une zone de courbe 47 délimite des courbes de diodes ou de modules d'éclairage à commander en tension.

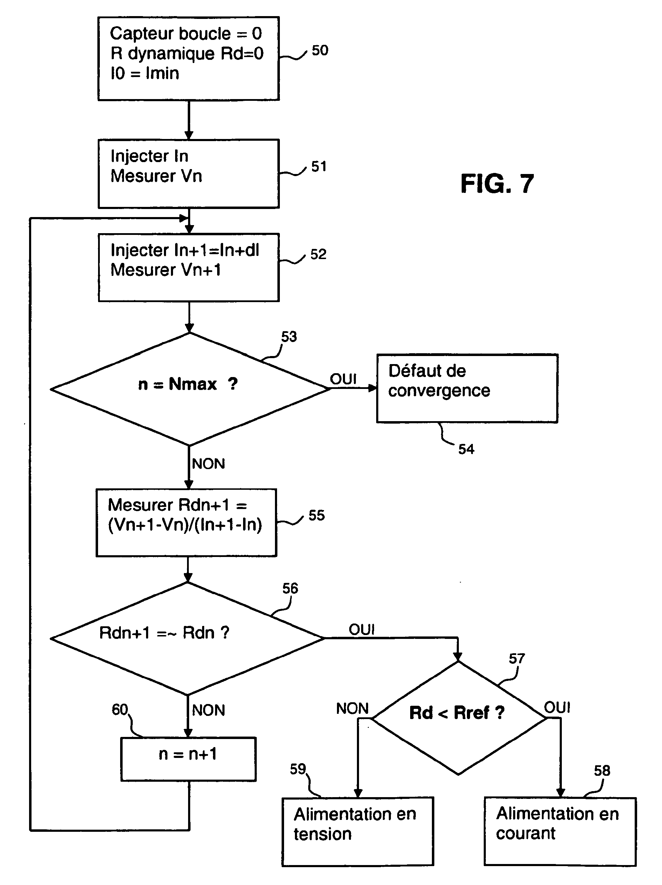

La figure 7 représente un organigramme détaillé de sélection de type de module d'éclairage pour un dispositif et un procédé selon un mode de réalisation de l'invention. Le circuit de traitement détecte le type de système d'éclairage à diodes électroluminescentes à alimenter en tension régulée ou en courant régulé. La détection de type comportant la détermination d'une résistance dynamique dudit système d'éclairage à diodes électroluminescentes et la comparaison de ladite résistance dynamique à un seuil. Par exemple, une valeur de ce seuil peut être de préférence 14 ohms.

Une étape 50 initialise des valeurs de nombre de boucles ou passages, de résistance dynamique et de courant d'injection minimum. Une étape 51 opère une première injection d'un courant In et la mesure d'une tension Vn. Une étape 52 opère une seconde injection d'un courant In+1 et la mesure d'une tension Vn+1. Une étape 53 détecte si le nombre maximal Nmax d'itérations est atteint. Si ce nombre Nmax est atteint une étape 54 signale un défaut de convergence. Une étape 55 détermine une nouvelle valeur de la résistance dynamique ou de pente. Puis une étape 56 contrôle si la résistance dynamique ou la pente est quasi stable, par exemple avec un écart de moins de 5%. Si la résistance dynamique ou la pente est stable alors une étape 57 compare la résistance dynamique ou la pente à une ou plusieurs références pour déterminer si le module d'éclairage est en alimentation en courant ou en tension. Ainsi si la résistance dynamique est inférieure à une référence, le module d'éclairage est alimenté en courant, étape 58, sinon la résistance dynamique est élevée et le module d'éclairage est alimenté en tension, étape 59. Si à l'étape 56 la résistance dynamique n'est pas stable, une étape 60 augmente un nombre n d'itérations. Puis un nouveau cycle d'injection et de mesure recommence.

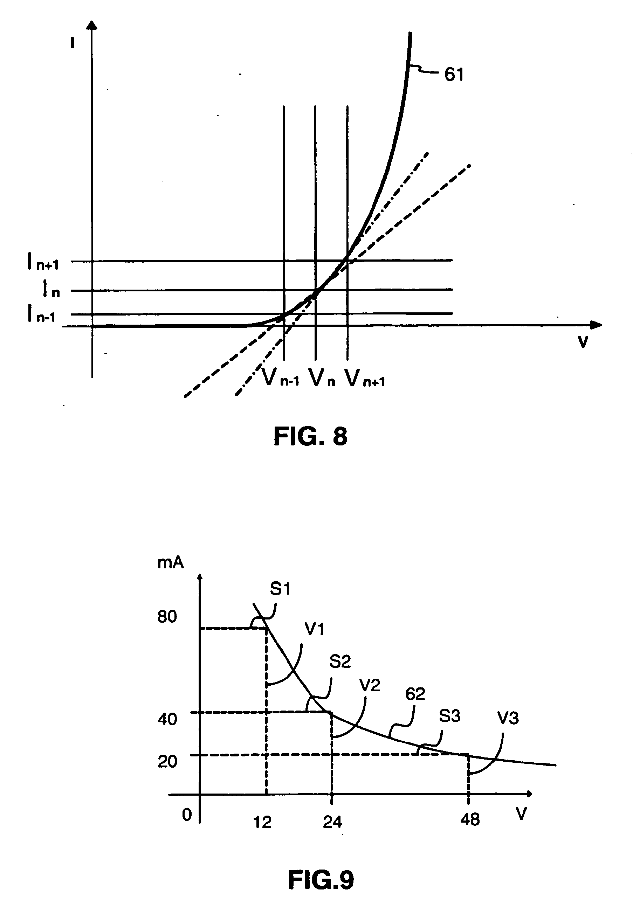

La figure 8 illustre une courbe 61 de caractéristiques électriques de modules d'éclairage pour déterminer la résistance dynamique dans des dispositifs et procédés selon un organigramme de la figure 7. L'allure de la résistance dynamique de cette courbe indique un module d'éclairage à alimenter en courant. Dans un autre mode de réalisation il est également possible de déterminer la valeur de la résistance dynamique à partir d'une courbe I. dV/dI = f(I).

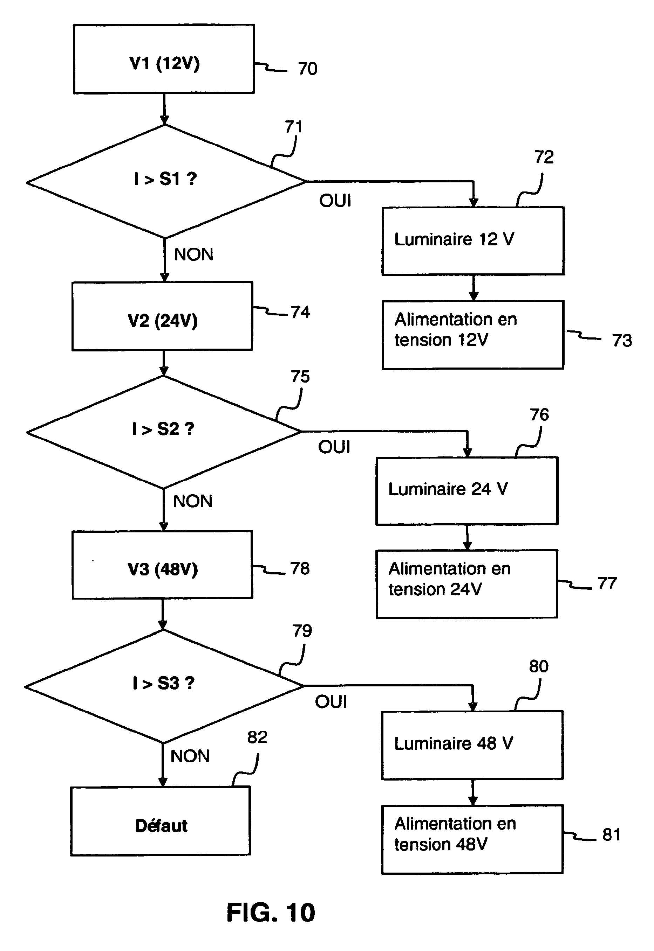

La figure 9 illustre une courbe de sélection de courant ou de tension pour des dispositifs et procédés selon des modes de réalisation de l'invention. Pour ce contrôle il est établi que les modules d'éclairage consomment un minimum de puissance, par exemple environ 1 watt. La courbe 62 définie une limite servant de référence de contrôle pour l'organigramme de la figure 10. La figure 10 représente un organigramme détaillé de sélection de tension d'alimentation dans un dispositif et un procédé selon un mode de réalisation de l'invention. Ainsi, le circuit de traitement commande l'injection de différentes valeurs de tension, et effectue la détection d'une tension d'alimentation en choisissant la valeur de tension la plus basse permettant de conduire un courant électrique d'alimentation supérieur à un seuil.

A une étape 70, une première tension basse V1 est appliquée au module d'éclairage. Puis une étape 71 contrôle si un premier seuil de courant S1 est dépassé. Si le seuil S1 est dépassé, une étape 72 indique que le module d'éclairage est à alimenter à la tension V1 et une étape 73 actionne l'alimentation du module d'éclairage. Si le seuil S1 n'est pas atteint, une seconde tension intermédiaire V2 est appliquée au module d'éclairage lors d'une étape 74. Puis une étape 75 contrôle si un second seuil de courant S2 est dépassé. Si le seuil S2 est dépassé, une étape 76 indique que le module d'éclairage est à alimenter à la tension V2 et une étape 75 actionne l'alimentation du module d'éclairage. Si le seuil S2 n'est pas atteint, une troisième tension haute V3 est appliquée au module d'éclairage à une étape 78. Puis une étape 79 contrôle si un troisième seuil de courant S3 est dépassé. Si le seuil S3 est dépassé, une étape 80 indique que le module d'éclairage est à alimenter à la tension V3 et une étape 81 actionne l'alimentation du module d'éclairage. Si le dernier seuil S3 n'est pas atteint, une étape 82 indique que le module d'éclairage est en défaut ou déconnecté. Dans l'organigramme ci-dessus les tensions V1, V2 et V3 peuvent avoir, par exemple, des valeurs respectivement de 12, 24 et 48 volts. Des exemples de seuils S1, S2 et S3 peuvent être de 80, 40 et 20 milliampères respectivement.

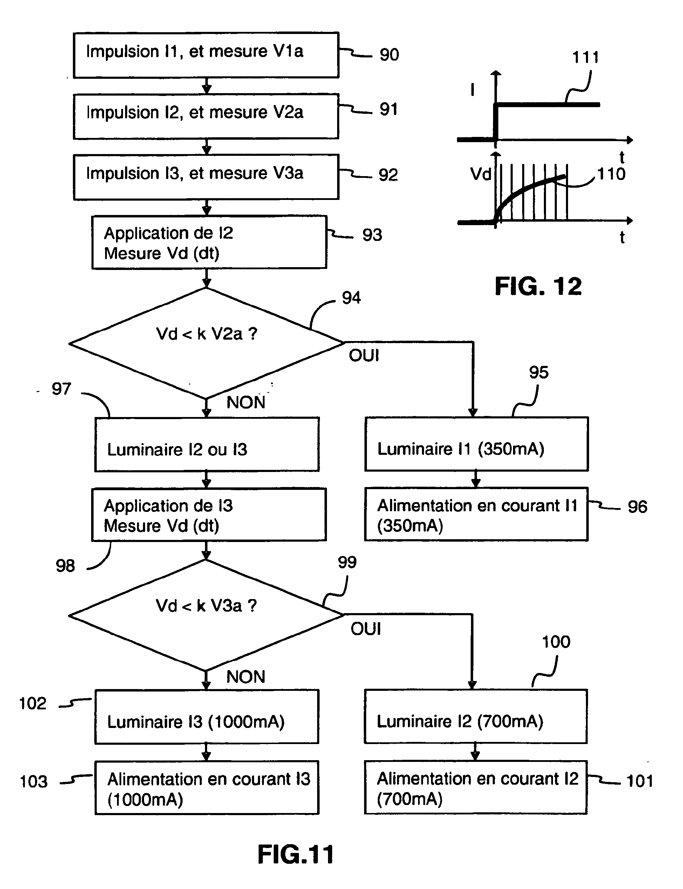

La figure 11 représente un organigramme détaillé de sélection de courant d'alimentation dans un dispositif et un procédé selon un mode de réalisation de l'invention. Dans ce cas, le circuit de traitement effectue :
- l'injection de différentes valeurs de courant pour déterminer des valeurs de tension directe à des températures ambiantes,
- la mémorisation d'au moins une valeur de tension directe du système d'éclairage à diodes électroluminescentes à une température ambiante ou à froid avant utilisation.
- l'injection de valeurs de courant et le contrôle de variations de tension directe, et
- la détection d'un courant d'alimentation en choisissant la valeur de courant la plus basse pour laquelle une tension directe est inférieure à une portion de la valeur de tension directe à une température ambiante préenregistrée.

Sur la figure 11 l'organigramme a une phase d'initialisation comprenant trois étapes 90, 91, 92 pendant lesquelles trois impulsions de courants I1 puis I2 puis I3 sont injectées. Pendant ces impulsions de courant, trois tensions à des températures ambiantes et/ou à froid avant utilisation, respectivement V1a, V2a et V3a sont mesurées et mémorisées. A une étape 93, un courant I2 est injecté et une mesure régulière de la tension directe Vd (dt) est effectuée pour évaluer la variation de la tension. Une étape 94 contrôle si la tension Vd est inférieure à proportion prédéterminé de la tension V2a à la température ambiante. Si Vd est inférieure à un pourcentage k de V2a, une étape 95 indique que le module d'éclairage doit être alimenté avec I1 et une étape 96 alimente le module d'éclairage en courant I1 par exemple 350 mA. Sinon, à une étape 97, il y a une seconde sélection entre un module d'éclairage en I2 et un module d'éclairage en I3. Par exemple k peut être de 94%. A une étape 98, un courant I3 est injecté et une mesure régulière de la tension directe Vd (dt) est effectuée pour évaluer la variation de la tension. Une étape 99 contrôle si la tension Vd est inférieure à proportion prédéterminé de la tension V3a à la température ambiante. Si Vd est inférieure à V3a, une étape 100 indique que le module d'éclairage doit être alimenté avec I2 et une étape 101 alimente le module d'éclairage en courant I2 par exemple 700 mA. Sinon une étape 102 indique que le module d'éclairage doit être alimenté avec I3 et une étape 103 alimente le module d'éclairage en courant I3 par exemple 1000 mA.

Ainsi, cette sélection de modules d'éclairage alimentés en courant est basée sur la variation de tension directe Vd en fonction de la température. La température de jonction est dépendante dans ce cas du passage des courants de test I2 est I3. La figure 12 illustre des courbes de variation de tension 110 en réponse à un courant 111 pour la sélection de courant I1, I2, et I3 d'alimentation dans des dispositifs et procédés selon des modes de réalisation de l'invention.

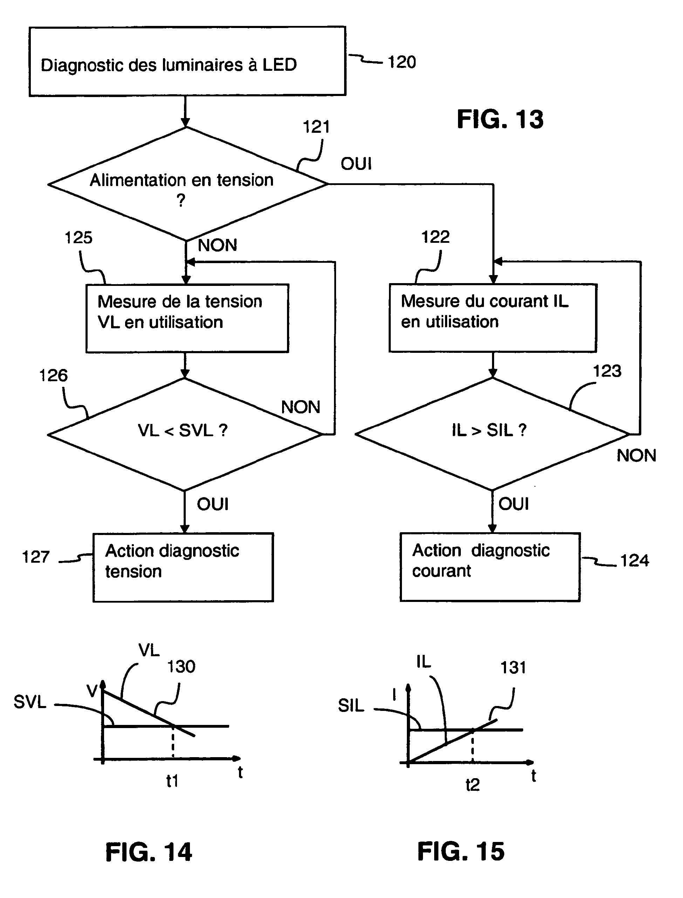

La figure 13 représente un organigramme de diagnostic pour un dispositif et un procédé selon un mode de réalisation de l'invention. Le circuit de traitement comporte des moyens de diagnostic pour détecter l'état des diodes en fonctionnement en fonction du type d'alimentation, lesdits moyens de traitement effectuant :
- un contrôle du courant lorsque le système d'éclairage à diodes électroluminescentes est alimenté en tension et/ou un contrôle de tension directe lorsque le système d'éclairage à diodes électroluminescentes est alimenté en courant, et
- la signalisation d'un défaut lorsque le courant dépasse un seuil si le système est alimenté en tension et/ou lorsque la tension directe devient inférieure à un seuil lorsque le système est alimenté en courant.

Le but du diagnostic est de déterminer si les modules d'éclairage restent dans des plages de température acceptables. Les causes possibles de dépassement de plages peuvent être par exemple une mauvaise installation, une dégradation des performances du module d'éclairage au cours du temps, ou un défaut de ventilation accidentel du module d'éclairage.

Une étape 120 initialise le diagnostic des modules d'éclairage, puis une étape 121 détecte si le module d'éclairage doit être alimenté en courant ou en tension. Cette étape peut comporter des organigrammes décrits ci-dessus. Pour un module d'éclairage alimenté en tension, une étape 122 mesure un courant IL d'alimentation en cours d'utilisation. Si le courant IL dépasse un seuil SIL à une étape 123, une étape 124 actionne le traitement du résultat du diagnostic. Pour un module d'éclairage alimenté en courant, une étape 125 mesure une tension VL d'alimentation en cours d'utilisation. Si la tension VL devient inférieure à un seuil SVL à une étape 126, une étape 127 actionne le traitement du résultat du diagnostic.

Le traitement du diagnostic des étapes 124 et 127 peuvent être par exemple une alarme, un arrêt de l'éclairage ou un réajustement automatique de l'alimentation. Ce traitement du diagnostic peut avoir aussi pour conséquence une réduction du niveau d'éclairage.

La figure 14 illustre une courbe 130 de variation de tension VL pour un diagnostic d'un système d'éclairage à diodes électroluminescentes à commande en courant. A un instant t1, la tension VL devient inférieure à un seuil SVL et le traitement du résultat du diagnostic est déclenché. La figure 15 illustre une courbe 131 de variation de courant IL pour un diagnostic d'un système d'éclairage à diodes électroluminescentes à commande en tension. A un instant t2, le courant IL dépasse le seuil ISL et le traitement du résultat du diagnostic est déclenché.

Les valeurs de courant et de tensions citées ci-dessus sont données comme exemples. L'invention peut être appliquée à d'autres tensions ou courants et à un nombre différents de valeurs de tension ou de courant.

L'invention peut s'appliquer à différents types de diodes électroluminescentes colorées ou blanches, réalisées selon diverses technologies par exemple AlInGaP ou InGaN.

Cette invention peut s'appliquer également aux diodes électroluminescentes organiques ou "OLED", réalisées selon différentes technologies.

## Revendications

1. Dispositif d'alimentation comportant :
- une alimentation (1, 7) à courant continu fournissant une tension ou un courant limité sur des sorties pour l'alimentation d'un système (3, 16-19) d'éclairage à diodes électroluminescentes, ladite alimentation comportant des moyens de mesure de tension (13, 14) et des moyens de mesure de courant (12) pour contrôler une tension et un courant d'alimentation, et
- des moyens de sélection (8, 9) de tension ou de courant connectés à ladite alimentation pour sélectionner si la charge est à alimenter en tension limitée ou en courant limité et selectionner la tension ou le courant à appliquer audit système d'éclairage à diodes électroluminescentes,
**caractérisé en ce qu'**il comporte des moyens de détection (15, 30) automatique de sens de branchement dudit système d'éclairage (3, 16-19) comportant :
- des moyens d'injection d'au moins une impulsion (31) de courant de test de polarité pour la détection (32) de passage de courant,
- des moyens de traitement (15) comportant des moyens de contrôle (32) de tension et de courant d'alimentation pendant l'impulsion de courant de test de polarité, et
- des moyens d'inversion (8, 9, 20A, 20B, 21A, 21B, 35) de sens de courant ou de tension commandés par lesdits moyens de traitement (15) pour le contrôle du sens de passage de courant et pour l'attribution (33) du sens de la tension ou du courant d'alimentation.

2. Dispositif selon la revendication 1 **caractérisé en ce que** lesdits moyens de traitement comportent des moyens de détection (37) de défaut si le courant d'alimentation est passant dans les deux sens ou bloqué dans les deux sens pendant l'impulsion de courant de test de polarité.

3. Dispositif selon l'une des revendications 1 ou 2 **caractérisé en ce que** lesdits moyens de traitement comportent des moyens de détection (40-43) de type de système d'éclairage à diodes électroluminescentes à alimentation en tension régulée ou en courant régulé, lesdits moyens de détection de type comportant des moyens de détermination (50-56) d'une résistance dynamique (Rd) dudit système d'éclairage à diodes électroluminescentes et des moyens de comparaison (57) de ladite résistance dynamique à un seuil (Rref).

4. Dispositif selon la revendication 3 **caractérisé en ce que** lesdits moyens de traitement comportent des moyens de détermination (70-81) d'une tension d'alimentation régulée pour un système d'éclairage à diodes électroluminescentes alimenté en tension comportant :
- des moyens (70, 74, 78) d'injection de valeurs de tension, et
- des moyens (71, 75, 79) de détection d'une tension d'alimentation en choisissant la valeur de tension la plus basse permettant de conduire un courant électrique d'alimentation supérieur à un seuil (S1, S2, S3).

5. Dispositif selon l'une des revendications 3 ou 4 **caractérisé en ce que** lesdits moyens de traitement comportent des moyens de détermination d'un courant d'alimentation régulé pour un système d'éclairage à diodes électroluminescentes alimenté en courant comportant :
- des moyens d'injection (90-92) des valeurs de courant (I1, 12, I3) pour déterminer des valeurs de tension directe à des températures ambiantes et/ou à froid avant utilisation,
- des moyens (93, 98) d'injection des valeurs de courant et de contrôle des variations de tension directe, et
- des moyens de détection (94, 99) d'un courant d'alimentation en choisissant la valeur de courant la plus basse pour laquelle une tension directe est inférieure à une portion de la valeur de tension directe à une température ambiante préenregistrée.

6. Dispositif selon l'une quelconque des revendications 1 à 5 **caractérisé en ce que** lesdits moyens de traitement comportent des moyens de diagnostic (120-124) pour détecter l'état des diodes électroluminescentes en fonctionnement, lesdits moyens de traitement comportant :
- des moyens (122, 123) de contrôle du courant lorsque le système d'éclairage à diodes électroluminescentes est alimenté en tension et/ou des moyens (125, 126) de contrôle de tension directe lorsque le système d'éclairage à diodes électroluminescentes est alimenté en courant, et
- des moyens (124, 127) de traitement d'un résultat de diagnostic lorsque le courant dépasse un seuil si le système est alimenté en tension et/ou lorsque la tension directe devient inférieure à un seuil lorsque le système est alimenté en courant.

7. Ensemble d'éclairage à diodes électroluminescentes comportant au moins un dispositif d'alimentation (1, 7-15) destiné à être connecté à un réseau d'alimentation électrique, au moins un système d'éclairage à diodes électroluminescentes (3, 16-19) connecté audit au moins un dispositif d'alimentation **caractérisé en ce que** le dispositif de d'alimentation est un dispositif selon les revendications 1 à 6 comportant des moyens de traitement (15) pour le traitement de la sélection automatique de l'alimentation dudit au moins un système d'éclairage à diodes électroluminescentes (3, 16-19).

8. Procédé d'alimentation pour système d'éclairage à diodes électroluminescentes comportant :
- la sélection si la charge est à alimenter en tension limitée ou en courant limité et la sélection d'une tension ou d'un courant d'alimentation à appliquer audit système d'éclairage à diodes électroluminescentes, et
- le contrôle (15) de ladite tension et dudit courant d'alimentation,
**caractérisé en ce qu'**il comporte la détection automatique (30-36) de sens de branchement dudit système d'éclairage en effectuant :
- l'injection d'au moins une impulsion (31) de courant de test de polarité pour la détection (32) de passage de courant,
- le contrôle (32) de ladite tension et dudit courant d'alimentation pendant l'impulsion de courant de test de polarité, et
- l'inversion (35) de sens de courant ou de tension pour le contrôle du sens de passage de courant et pour l'attribution du sens de la tension ou du courant d'alimentation.

9. Procédé d'alimentation selon la revendication 8 **caractérisé en ce qu'**il comporte la détection (37) de défaut si le courant d'alimentation est passant dans les deux sens ou bloqué dans les deux sens pendant l'impulsion de courant de test de polarité.

10. Procédé d'alimentation selon l'une des revendications 8 ou 9 **caractérisé en ce qu'**il comporte la détection (40-43) de type de système d'éclairage à diodes électroluminescentes à alimentation en tension régulée ou en courant régulé en effectuant :
- la détermination (50-56) d'une résistance dynamique (Rd) dudit système d'éclairage à diodes électroluminescentes, et
- la comparaison (57) de ladite résistance dynamique à un seuil (Rref).

11. Procédé d'alimentation selon l'une des quelconque des revendications 8 à 10 **caractérisé en ce qu'**il comporte la détermination (70-81) d'une tension d'alimentation régulée pour un système d'éclairage à diodes électroluminescentes alimenté en tension comportant :
- l'injection (70, 74, 78) de différentes valeurs de tension, et
- la détection (71, 75, 79) d'une tension d'alimentation en choisissant la valeur de tension la plus basse permettant de conduire un courant électrique d'alimentation supérieur à un seuil (S1, S2, S3).

12. Procédé d'alimentation selon l'une des quelconque des revendications 8 à 11 **caractérisé en ce qu'**il comporte la détermination d'un courant d'alimentation régulé pour un système d'éclairage à diodes électroluminescentes alimenté en courant comportant :
- l'injection (90-92) de différentes valeurs de courant (I1, I2, 13) pour déterminer des valeurs de tension directe à des températures ambiantes,
- l'injection (93, 98) de valeurs de courant et le contrôle de variations de tension directe, et
- la détection (94, 99) d'un courant d'alimentation en choisissant la valeur de courant la plus basse pour laquelle une tension directe est inférieure à une portion de la valeur de tension directe à une température ambiante préenregistrée.

13. Procédé d'alimentation selon l'une des quelconque des revendications 8 à 12 **caractérisé en ce qu'**il comporte la mémorisation (90, 91, 92) d'au moins une valeur de tension directe du système d'éclairage à diodes électroluminescentes à une température ambiante ou à froid avant utilisation.

14. Procédé d'alimentation selon l'une des quelconque des revendications 8 à 13 **caractérisé en ce qu'**il comporte un diagnostic pour détecter l'état des diodes électroluminescentes en fonctionnement, et comportant :
- un contrôle (122, 123) du courant lorsque le système d'éclairage à diodes électroluminescentes est alimenté en tension et/ou un contrôle (125, 126) de tension directe lorsque le système d'éclairage à diodes électroluminescentes est alimenté en courant, et
- le traitement (124, 127) d'un résultat de diagnostic lorsque le courant dépasse un seuil si le système est alimenté en tension et/ou lorsque la tension directe devient inférieure à un seuil lorsque le système est alimenté en courant.

## Patentansprüche

1. Stromversorgungseinrichtung mit
- einer Gleichstromversorgung (1, 7), die an ihren Ausgängen eine Spannung oder einen begrenzten Strom zur Energieversorgung eines Beleuchtungssystems mit Leuchtdioden (3, 16-19) liefert, welche Stromversorgung Spannungsmessmittel (13, 14) und Strommessmittel (12) zur Überprüfung einer Versorgungsspannung bzw. eines Versorgungsstroms sowie
- an die genannte Stromversorgung angeschlossenen Spannungs- bzw. Stromauswahlmitteln (8, 9), die dazu dienen zu erkennen, ob die Last mit Spannungsbegrenzung oder mit Strombegrenzung eingespeist werden muss, und um die erforderliche Versorgungsspannung bzw. den erforderlichen Versorgungsstrom für das genannte Beleuchtungssystem mit Leuchtdioden auszuwählen,
**dadurch gekennzeichnet, dass** die Einrichtung Detektiermittel (15, 30) zur automatischen Erkennung der Anschlusspolung des genannten Beleuchtungssystems (3, 16-19) umfasst, welche Detektiermittel
- Mittel zur Injizierung mindestens eines Polaritätsprüfungs-Stromimpulses (31) zur Erkennung (32) eines Stromdurchgangs,
- Verarbeitungsmittel (15) mit Prüfmitteln (32) zur Überprüfung der Versorgungsspannung bzw. des Versorgungsstroms während des Polaritätsprüfungs-Stromimpulses sowie
- Invertiermittel (8, 9, 20A, 20B, 21A, 21 B, 35) zur Umkehrung der Stromrichtung bzw. Spannungsrichtung umfassen, welche Invertiermittel von den genannten Verarbeitungsmitteln (15) angesteuert werden, um die Stromdurchgangsrichtung zu prüfen und eine Versorgungsstrom- bzw. Versorgungsspannungsrichtung zuzuweisen (33).

2. Einrichtung nach Anspruch 1, **dadurch gekennzeichnet, dass** die genannten Verarbeitungsmittel Fehlererkennungsmittel (37) umfassen, die während des Polaritätsprüfungs-Stromimpulses als Fehler erkennen, wenn der Versorgungsstrom in beiden Richtungen durchgängig oder in beiden Richtungen gesperrt ist.

3. Einrichtung nach einem der Ansprüche 1 oder 2, **dadurch gekennzeichnet, dass** die genannten Verarbeitungsmittel Detektiermittel (40-43) zur Erkennung der Art des Beleuchtungssystems in Bezug auf seine spannungsgeregelte oder stromgeregelte Energieversorgung umfassen, welche Detektiermittel Mittel (50-56) zur Bestimmung eines dynamischen Widerstands (Rd) des genannten Beleuchtungssystems mit Leuchtdioden sowie Mittel (57) zum Vergleich des genannten dynamischen Widerstands mit einem Schwellwert (Rref) umfassen.

4. Einrichtung nach Anspruch 3, **dadurch gekennzeichnet, dass** die genannten Verarbeitungsmittel Mittel (70-81) zur Bestimmung einer geregelten Versorgungsspannung für ein spannungsgeregeltes Leuchtdioden-Beleuchtungssystem umfassen, welche Bestimmungsmittel:
- Mittel (70, 74, 78) zur Injizierung von Spannungswerten sowie
- Detektiermittel (71, 75, 79) zur Bestimmung einer Versorgungsspannung durch Auswahl des kleinsten Spannungswertes umfasst, der den Fluss eines, über einem Schwellwert (S1, S2, S3) liegenden Versorgungsstroms erlaubt.

5. Einrichtung nach einem der Ansprüche 3 oder 4, **dadurch gekennzeichnet, dass** die genannten Verarbeitungsmittel Mittel zur Bestimmung eines geregelten Versorgungsstroms für ein stromgeregeltes Leuchtdioden-Beleuchtungssystem umfassen, welche Bestimmungsmittel
- Mittel (90-92) zur Injizierung von Stromwerten (11, I2, I3), um vor der Verwendung Durchlassspannungswerte bei Umgebungstemperatur und /oder bei Kälte zu bestimmen,
- Mittel (93, 98) zur Injizierung von Stromwerten und Überprüfung von Veränderungen der Durchlassspannung sowie
- Detektiermittel (94, 99) zur Bestimmung eines Versorgungsstroms durch Auswahl des kleinsten Stromwerts umfasst, bei dem eine Durchlassspannung kleiner ist als ein Teilwert der zuvor erfassten Durchlassspannung bei Umgebungstemperatur.

6. Einrichtung nach irgendeinem der Ansprüche 1 bis 5, **dadurch gekennzeichnet, dass** die genannten Verarbeitungsmittel Diagnosemittel (120-124) zur Erkennung des Betriebszustands der Leuchtdioden umfassen, welche Verarbeitungsmittel
- Prüfmittel (122, 123) zur Überprüfung des Stroms bei spannungsgeregelter Versorgung des Beleuchtungssystems mit Leuchtdioden und/oder Prüfmittel (125, 126) zur Überprüfung der Spannung bei stromgeregelter Versorgung des Beleuchtungssystems mit Leuchtdioden sowie
- Verarbeitungsmittel (124, 127) umfassen, die dazu dienen, ein Diagnoseergebnis zu verarbeiten, wenn bei spannungsgeregelter Versorgung des Systems der Strom einen bestimmten Schwellwert überschreitet und/oder wenn bei stromgeregelter Versorgung des Systems die Durchlassspannung einen bestimmten Schwellwert unterschreitet.

7. Beleuchtungsanlage mit Leuchtdioden, die mindestens eine Stromversorgungseinrichtung (1, 7-15) zum Anschluss an ein elektrisches Einspeisenetz und mindestens ein an die genannte mindestens einfach vorhandene Stromversorgungseinrichtung angeschlossenes Beleuchtungssystem mit Leuchtdioden (3, 16-19) umfasst, **dadurch gekennzeichnet, dass** die Stromversorgungseinrichtung als Einrichtung nach Anspruch 1 bis 6 ausgebildet ist, welche Einrichtung Verarbeitungsmittel (15) zur Verarbeitung der automatischen Auswahl der Stromversorgung des genannten, mindestens einfach vorhandenen Beleuchtungssystems mit Leuchtdioden (3, 16-19) umfasst.

8. Stromversorgungsverfahren für ein Beleuchtungssystem mit Leuchtdioden, das
- die Entscheidung, ob die Last mit Spannungsbegrenzung oder mit Strombegrenzung eingespeist werden muss, die Auswahl einer Spannung oder eines Stroms, mit dem das genannte Beleuchtungssystem mit Leuchtdioden versorgt werden muss, sowie die Überprüfung (15) der genannten Versorgungsspannung bzw. des genannten Versorgungsstroms umfasst,
**dadurch gekennzeichnet, dass** es die automatische Erkennung (30-36) der erforderlichen Anschlusspolung des genannten Beleuchtungssystems umfasst, indem es
- mindestens einen Polaritätsprüfungs-Stromimpuls (31) zur Erkennung (32) eines Stromdurchgangs injiziert,
- die genannte Versorgungsspannung bzw. den genannten Versorgungsstrom während des Polaritätsprüfungs-Stromimpulses überprüft (32),
- die Strom- oder Spannungsrichtung umkehrt (35), um die Stromdurchgangsrichtung zu prüfen und die Richtung der Versorgungsspannung bzw. des Versorgungsstroms zuzuweisen.

9. Stromversorgungsverfahren nach Anspruch 8, **dadurch gekennzeichnet, dass** es bei Injizierung des Polaritätsprüfungs-Stromimpulses als Fehler erkennt (37), wenn der Strom in beiden Richtungen durchgängig oder in beiden Richtungen gesperrt ist.

10. Stromversorgungsverfahren nach einem der Ansprüche 8 oder 9, **dadurch gekennzeichnet, dass** es die Erkennung (40-43) der Art des Beleuchtungssystems mit Leuchtdioden umfasst und unterscheidet, ob es sich um ein System mit spannungsgeregelter oder stromgeregelter Energieversorgung handelt, indem es
- einen dynamischen Widerstand (Rd) des genannten Beleuchtungssystems mit Leuchtdioden bestimmt (50-56) und
- den genannten dynamischen Widerstand mit einem Schwellwert (Rref) vergleicht (57).

11. Stromversorgungsverfahren nach irgendeinem der Ansprüche 8 bis 10, **dadurch gekennzeichnet, dass** es die Bestimmung (70-81) einer geregelten Versorgungsspannung für ein spannungsgeregeltes Beleuchtungssystem mit Leuchtdioden umfasst, indem es
- verschiedene Spannungswerte injiziert (70, 74, 78) sowie
- eine Versorgungsspannung durch Bestimmung des kleinsten Spannungswertes (71, 75, 79) erkennt, der den Fluss eines, über einem Schwellwert (S1, S2, S3) liegenden Versorgungsstroms erlaubt.

12. Stromversorgungsverfahren nach irgendeinem der Ansprüche 8 bis 11, **dadurch gekennzeichnet dass** es die Bestimmung (70-81) eines geregelten Versorgungsstroms für ein stromgeregeltes Beleuchtungssystem mit Leuchtdioden umfasst, indem es
- verschiedene Stromwerte (I1, I2, I3) injiziert (90-92), um die Werte der Durchlassspannung bei Umgebungstemperatur zu bestimmen,
- Stromwerte injiziert (93, 98) und Veränderungen der Durchlassspannung überprüft sowie
- einen Versorgungsstrom durch Bestimmung des kleinsten Stromwerts erkennt (94, 99), bei dem eine Durchlassspannung kleiner ist als ein Teilwert der vorab erfassten Durchlassspannung bei Umgebungstemperatur.

13. Stromversorgungsverfahren nach irgendeinem der Ansprüche 8 bis 12, **dadurch gekennzeichnet, dass** es vor der Verwendung die Speicherung (90, 91, 92) mindestens eines Durchlassspannungswertes des Leuchtdioden-Beleuchtungssystems bei Umgebungstemperatur oder Kälte umfasst.

14. Stromversorgungsverfahren nach irgendeinem der Ansprüche 8 bis 13, **dadurch gekennzeichnet, dass** es eine Diagnose zur Erkennung des Betriebszustands der Dioden umfasst, welche Diagnose
- die Überprüfung (122, 123) des Stroms bei spannungsgeregelter Versorgung des Leuchtdioden-Beleuchtungssystems und/oder die Überprüfung (125, 126) der Durchlassspannung bei stromgeregelter Versorgung des Leuchtdioden-Beleuchtungssystems sowie
- die Verarbeitung (124, 127) eines Diagnoseergebnisses umfasst, wenn bei spannungsgeregelter Versorgung des Systems der Strom einen bestimmten Schwellwert überschreitet und/oder bei stromgeregelter Versorgung des Systems die Durchlassspannung einen bestimmten Schwellwert unterschreitet.

## Claims

1. Power supply device comprising:
- a DC power supply (1, 7) providing a limited voltage or current at outputs for the power supply of a light-emitting diode lighting system (3, 16-19), the said power supply comprising voltage measurement means (13, 14) and current measurement means (12) for controlling a supply voltage and current, and
- voltage or current selection means (8, 9) connected to the said power supply for selecting whether the load is to be powered in limited voltage mode or in limited current mode and selecting the voltage or the current to be applied to the said light-emitting diode lighting system,
**characterized in that** it comprises means for automatically detecting (15, 30) the direction of connection of the said lighting system (3, 16-19) comprising:
- means for injecting at least one polarity test current pulse (31) for the detection (32) of current flow,
- processing means (15) comprising means (32) for controlling the supply voltage and current during the polarity test current pulse, and
- current or voltage direction inversion means (8, 9, 20A, 20B, 21A, 21B, 35) controlled by the said processing means (15) for controlling the direction of flow of the current and for assigning (33) the direction of the supply voltage or current.

2. Device according to Claim 1, **characterized in that** the said processing means comprise means for detecting a fault (37) if the supply current is flowing in both directions or off in both directions during the polarity test current pulse.

3. Device according to either of Claims 1 and 2, **characterized in that** the said processing means comprise means for detecting (40-43) the type of light-emitting diode lighting system using a voltage or current regulated power supply, the said type detection means comprising means for determining (50-56) a dynamic resistance (Rd) of the said light-emitting diode lighting system and means for comparison (57) of the said dynamic resistance with a threshold (Rref).

4. Device according to Claim 3, **characterized in that** the said processing means comprise means for determining (70-81) a regulated supply voltage for a light-emitting diode lighting system powered in voltage mode comprising:
- means (70, 74, 78) for injecting voltage values, and - means (71, 75, 79) for detecting a supply voltage by choosing the lowest value of voltage allowing a supply electrical current higher than a threshold (S1, S2, S3) to be conducted.

5. Device according to either of Claims 3 and 4, **characterized in that** the said processing means comprise means for determining a regulated supply current for a light-emitting diode lighting system powered in current mode comprising:
- means for injecting (90-92) current values (I1, I2, I3) in order to determine DC voltage values at ambient temperatures and/or cold prior to use,
- means (93, 98) for injecting current values and for controlling the variations in DC voltage, and
- means for detecting (94, 99) a supply current by choosing the lowest value of current for which a DC voltage is lower than a portion of the value of DC voltage at a pre-recorded ambient temperature.

6. Device according to any one of Claims 1 to 5, **characterized in that** the said processing means comprise diagnostic means (120-124) for detecting the state of the light-emitting diodes in operation, the said processing means comprising:
- means (122, 123) for controlling the current when the light-emitting diode lighting system is powered in voltage mode and/or means (125, 126) for controlling the DC voltage when the light-emitting diode lighting system is powered in current mode, and
- means (124 127) for processing a diagnostic result when the current exceeds a threshold if the system is powered in voltage mode and/or when the DC voltage falls below a threshold when the system is powered in current mode.

7. Lighting assembly using light-emitting diodes comprising at least one power supply device (1, 7-15) designed to be connected to a electrical supply system, at least one light-emitting diode lighting system (3, 16-19) connected to the said at least one power supply device **characterized in that** the power supply device is a device according to Claims 1 to 6 comprising processing means (15) for the processing of the automatic selection of the power supply for the said at least one light-emitting diode lighting system (3, 16-19).

8. Power supply method for a light-emitting diode lighting system comprising:
- the selection of whether the load is to be supplied in limited voltage mode or in limited current mode and the selection of a supply voltage or current to be applied to the said light-emitting diode lighting system, and
- the control (15) of the said supply voltage and of the said supply current, **characterized in that** it comprises the automatic detection (30-36) of the direction of connection of the said lighting system by carrying out:
- the injection of at least one polarity test current pulse (31) for the detection (32) of current flow,
- the control (32) of the said supply voltage and of the said supply current during the polarity test current pulse, and
- the inversion (35) of the current or voltage direction for the control of the direction of current flow and for the assignment of the direction of the supply voltage or current.

9. Power supply method according to Claim 8, **characterized in that** it comprises the detection (37) of a fault if the supply current is flowing in both directions or off in both directions during the polarity test current pulse.

10. Power supply method according to either of Claims 8 and 9, **characterized in that** it comprises the detection (40-43) of the type of light-emitting diode lighting system using a voltage- or current-regulated power supply by carrying out:
- the determination (50-56) of a dynamic resistance (Rd) of the said light-emitting diode lighting system, and
- the comparison (57) of the said dynamic resistance with a threshold (Rref).

11. Power supply method according to any one of Claims 8 to 10, **characterized in that** it comprises the determination (70-81) of a regulated supply voltage for a light-emitting diode lighting system powered in voltage mode comprising:
- the injection (70, 74, 78) of various voltage values, and
- the detection (71, 75, 79) of a supply voltage by choosing the lowest value of voltage allowing an electrical supply current higher than a threshold (S1, S2, S3) to flow.

12. Power supply method according to any one of Claims 8 to 11, **characterized in that** it comprises the determination of a regulated supply current for a light-emitting diode lighting system powered in current mode comprising:
- the injection (90-92) of various current values (I1, I2, I3) for determining DC voltage values at ambient temperatures,
- the injection (93, 98) of current values and the control of variations in DC voltage, and
- the detection (94, 99) of a supply current by choosing the lowest value of current for which a DC voltage is lower than a portion of the DC voltage value at a pre-recorded ambient temperature.

13. Power supply method according to any one of Claims 8 to 12, **characterized in that** it comprises the storage (90, 91, 92) of at least one value of DC voltage for the light-emitting diode lighting system at an ambient temperature or cold prior to use.

14. Power supply method according to any one of Claims 8 to 13, **characterized in that** it comprises a diagnostic for detecting the state of the light-emitting diodes in operation, and comprising:
- a control (122, 123) of the current when the light-emitting diode lighting system is powered in voltage mode and/or a control (125, 126) of DC voltage when the light-emitting diode lighting system is powered in current mode, and
- the processing (124, 127) of a diagnostic result when the current exceeds a threshold if the system is powered in voltage mode and/or when the DC voltage falls below a threshold when the system is powered in current mode.
